# EUROPEAN PATENT SPECIFICATION

(11) **EP 1 297 558 B1**
(45) Date of publication and mention of the grant of the patent: **20.04.2011**
(21) Application number: 01950554.4
(22) Date of filing: 26.06.2001
(51) Int. Cl.: H01L 21/00

(54) **SILICON FIXTURES FOR SUPPORTING WAFERS DURING THERMAL PROCESSING AND METHOD OF FABRICATION**
SILIZIUM-BEFESTIGUNGEN FÜR SCHEIBENHALTERVORRICHTUNG ZUR WÄRMEBEHANDLUNG UND HERSTELLUNGSVERFAHREN
SUPPORT DE SILICIUM DESTINE A PORTER DES PLAQUETTES AU COURS D'UN TRAITEMENT THERMIQUE ET PROCEDE DE FABRICATION

(30) Priority: 30.06.2000 US 608557; 30.06.2000 US 608291
(43) Date of publication of application: 02.04.2003
(73) Proprietor: Integrated Materials, Inc., San Jose, CA 95112 (US)
(72) Inventor: BOYLE, James, E., Saratoga, CA 95070 (US); DAVIS, Robert L., Belmont, CA 94002 (US); DELANEY, Laurence, D., Whitefish, MO 59937 (US); ZEHAVI, Raanan, Y., Sunnyvale, CA 94087 (US)
(74) Representative: Cross, Rupert Edward Blount
(86) International application number: PCT/US2001/020474
(87) International publication number: WO 2002/003428

(56) References cited:
- EP-A- 0 807 961
- EP-A- 0 884 769
- EP-A- 1 006 564
- EP-A1- 1 006 564
- EP-A2- 0 783 175
- WO-A-00/21119
- WO-A1-00/21119
- GB-A- 1 385 730
- US-A- 3 640 398
- US-A- 4 566 839
- US-A- 4 767 251
- US-A- 5 492 229
- US-A- 5 492 229
- US-A- 5 586 880
- US-A- 5 586 880

## Description

### BACKGROUND OF THE INVENTION

### 1. Field of the Invention

The invention relates generally to fixtures used for supporting wafers in the fabrication of semiconductor integrated circuits. In particular, the invention relates to silicon fixtures, such as towers and boats, for supporting wafers during thermal processing.

### 2. Technical Background

In the evolution of commercial fabrication of silicon wafers, larger and larger wafers are being processed in larger and larger batches at the same time that feature sizes are decreasing to 0.18µm and less. Such processing has imposed increasingly more demanding requirements on the performance of processing equipment, as well as that of the wafer handling and carrying mechanisms needed to move, transport, and retain the wafers during processing. These requirements include temperature uniformity and contamination, whether of impurities and/or particles.

In many chemical and thermal processing operations, it is often necessary to hold the wafers in precise positions during various processing steps, and in particular during annealing, dopant diffusion, or chemical vapor deposition simultaneously performed on many wafers. Many of these processes are performed at moderately high to very high temperatures. The medium temperatures are in the range of 400 to 700°C while the high temperatures are in the range of 1000 to 1380°C. The upper limit is substantially limited by the melting point of silicon at about between 1412°C and 1416°C, further taking into account any significant softening at just below the melting point.

Support fixtures are typically employed to support a relatively large quantity of wafers in an oven or other high-temperature reactor for such thermal processing. A "boat" is the term usually applied to a fixture holding multiple wafers with their principal surfaces extending in approximately vertical planes with the wafers spaced along a horizontal axis. A boat is used in a horizontal furnace. A "tower" is the term usually applied to a fixture holding multiple wafers with their principal surfaces lying within generally horizontal planes with the wafers spaced along a vertical axis. A tower is used in a vertical furnace. The term "tower" will be used in the following discussion because they are most common in large-scale commercial fabrication processes, but most of the comments apply equally well to boats.

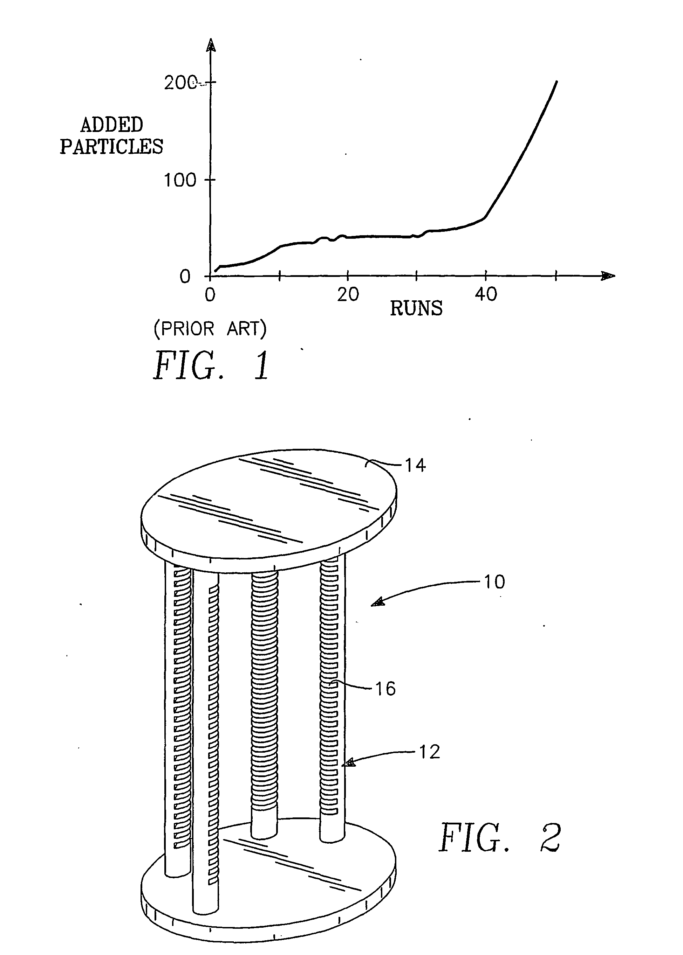

In the past, most towers and boats have been formed of quartz, which is relatively inexpensive and relatively clean. However, quartz will devitrify at higher temperatures to form crystallites. Any such crystallites can be easily dislodged from the amorphous matrix rendering the support fixtures dirty when used at higher temperatures. Also, quartz tends to sag at somewhat higher temperatures, which makes it unsuitable for large structures required for processing a large number of large wafers. Even at lower temperatures, devitrified quartz has a tendency to fracture catastrophically as cracks propagate in the quartz. Data from the fab lines have shown that the number of particles added from a quartz tower increases with the number of runs in a pattern such as that illustrated in FIG. 1. Up to about ten runs, the number of particles increases to a level of about 50 per 200mm wafer, which is barely tolerable. The particle count is maintained at this level up to about 40 runs, at which point the production of particles quickly becomes unacceptable. In light of these data and anticipated variations in the performance, it has become common practice to substitute a fresh tower after about 30 runs and to discard the old fixture. While this practice may be economically justified in view of the value of processed wafers, it represents a large expense.

As a result, towers for high-temperature applications are often formed of silicon carbide (SiC), which is usually sintered, so devitrification is not a problem, and its melting point is a relatively high 2830°C. However, since sintered silicon carbide is almost always contaminated with metals, it is common to coat the sintered SiC with a thin layer of SiC deposited by chemical vapor deposition (CVD), which is much cleaner. The CVD coating makes SiC fixtures much more expensive. Also, even a single pinhole in the CVD coating is likely to render the entire tower unusable.

Suggestions exist in the literature for forming towers from silicon. By fabricating wafer holding structures from the same material as the wafers themselves, that is, silicon, the possibility of contamination and deformation is reduced. The silicon structure would react to processing temperatures, conditions, and chemistry in exactly the same way that the wafers would, thus greatly enhancing the overall effective useful life of the structure. Silicon is widely available in the larger sizes required for towers as either monocrystalline or polysilicon grown by the Czochralski (CZ) method.

Czochralski monocrystalline silicon is the type used as wafers in semiconductor integrated circuits and consists of essentially a single crystal of silicon. The Czochralski single crystals are called ingots and are shaped generally as rods with diameters of extending to 200 and 300mm, the sizes of the most commercially important wafers, and lengths of 1m or more. The thin wafers are sawn from the monocrystalline ingot. In the Czochralski method, silicon source material typically in the form of virgin polycrystalline silicon to be described later is heated in a crucible to above silicon's melting point of about 1416°C, perhaps with intentionally introduced dopants. A single crystal of silicon is nucleated on a small seed crystal placed at the surface of the melt, and the growing ingot is very slowly pulled from the melt in the form of a single-crystal rod.

CZ polycrystalline silicon, often referred to as semi-single crystal silicon, is grown by substantially the same method and has virtually the same local structure as monocrystalline silicon but is composed of separate crystallites of substantial sizes. The crystallites have sizes of the order of 1mm to above 100mm and are separated by grain boundaries. Such CZ polysilicon is believed to be the conventionally presented polysilicon in the context of structural members. Whether CZ silicon is grown in monocrystalline or polycrystalline form depends in large part upon its drawing rate from the melt.

CZ silicon, whether monocrystalline or polycrystalline, is typically grown with heavy metal impurities of somewhat less than 1 part per million (ppm), but carbon and nitrogen may be present in concentrations between 1 and 7ppm, while oxygen is present in concentrations between 10 and 25ppm. The crystallites of CZ polysilicon typically have very similar orientations with respect to each other. Polysilicon is often grown as thin layers in silicon integrated circuits by chemical vapor deposition, but such films are not directly applicable to the invention.

To date, however, such silicon towers have not found acceptance in the industry. Silicon is perceived as being extremely fragile and difficult to fuse. Other methods of securing together silicon pieces are unlikely to survive the highest required wafer processing temperatures. It is believed that the standard assembly techniques used with silicon members have been unsatisfactory and has resulted in flimsy structures unsuited to commercial use. Due to these perceptions, known silicon structures are widely believed to be delicate at best, and unreliably flimsy at worst. Consequently, they have failed to receive broad commercial acceptance.

It can be seen that a need exists for a method of fabricating monocrystalline and polycrystalline silicon structural members for use in the manufacture semiconductor wafers and the like that will eliminate the disadvantages of known silicon structures while retaining the advantages of silicon as a structural material.

It can thus be seen that the need exists for clean, strong, and reliable support members for wafer processing fixtures that will reduce shadowing end contamination while providing stable and precise wafer support.

Ranaan and Davis in U.S. Patents 6,196,211, 6,205,993, and 6,225,491 have disclosed silicon towers formed of either monocrystalline or polycrystalline silicon and have further described methods of securing together pieces of the tower. These patents are incorporated herein by reference in their entireties. The present inventions are improvements on those disclosures.

US-A-5586880 discloses a silicon wafer tower or boat having three polysilicon legs extending between bases and teeth formed along the legs to support the wafers.

EP-A-1006564 discloses a wafer holding structure comprising multiple legs extending between bases, all of polysilicon.

### SUMMARY OF THE INVENTION

A silicon tower is used to support multiple silicon wafers in parallel spaced apart relationships during thermal processing. The referred configuration includes multiple silicon legs joined at their ends to silicon bases. The legs may have lateral slots cut in the legs to form, in the case of vertically extending towers, projecting teeth to support the wafers horizontally or, in the case of vertically extending boats, a rack to hold the wafers vertically.

In one aspect the invention provides a method of forming a silicon tower as set out in claim 1. The invention also provides a silicon tower as set out in claim 7.

The legs and also the base of the silicon tower may be machined from virgin polysilicon formed by the chemical vapour deposition of silicon, preferably from monosilane. The silicon material advantageously has an impurity concentration of metal components of less than 1 parts per billion and a resistivity of greater than 1000 ohm-cm.

The legs may have a larger back portion and a smaller projecting portion for supporting the wafer, thus minimizing thermal shadowing. The projecting portion may be inclined upwardly at between 1° and 3° and have a level support portion on its end. The support portion of the legs is advantageously polished to a mirror finish. The projecting portion advantageously supports the wafer at between 69% and 72% of the wafer radius to minimize stress on the wafer.

Virgin polysilicon is machined after it has been annealed above its plasticizing temperature of 1025°C or alternatively at more than 100°C above the thermal CVD temperature used in forming the virgin polysilicon.

Silicon parts are preferably annealed in an oxygen ambient after machining and before joining. The annealing temperature is preferably between 1025°C and 1416°C.

Silicon parts are joined by applying a spin-on glass composition to the joining surfaces. A spin-on glass includes silicon and oxygen components that are converted to a silicate glass when annealed to above 600°C. Preferably, the joined parts are annealed at above 1025°C.

Advantageously, the annealed joined parts of a wafer support fixture are subjected to sub-surface work damage prior to use in a wafer processing furnace.

Wafer bearing surfaces maybe polished to a mirror finish, preferably after annealing and sub-surface working.

### BRIEF DESCRIPTION OF THE DRAWINGS

FIG.1 illustrates the increasing number of particles produced by a quartz tower under continued use.
FIG. 2 is an orthographic view of a first embodiment of a silicon wafer processing fixture (tower) incorporating the principles of the present invention.
FIG. 3 is an orthographic view of the assembly of a leg and a base of the tower of FIG. 2. tower of FIG. 2.
FIG. 4 is a side cross sectional view of a second embodiment of a silicon tower of the invention.
FIG. 5 is an axial plan view of the leg of the silicon tower of FIG. 4.
FIG. 6 is an orthographic view of a tower using the leg of FIGS. 4 and 5.
FIG. 7 is a process flow diagram of a method of fabricating a virgin polysilicon structure.
FIG. 8 is an orthographic view of a multi-part tower base.
FIG. 9 is an orthographic view of a horizontally arranged fixture (boat).

### DETAILED DESCRIPTION OF THE PREFERRED EMBODIMENTS

Rugged but light silicon towers and other wafer supporting fixtures can be fabricated, but care should be exercised in the type of silicon used, in the processing and machining of silicon, and the type of method used to secure two silicon members together.

A silicon wafer tower 10 readily achievable with the invention is illustrated in the orthographic view of FIG. 2. The silicon tower 10 includes a plurality of generally elongate support members 12, hereinafter called legs, secured between a pair of generally planar base members 14, hereinafter called bases. A plurality of horizontal slots 16 are cut into each of the tower legs 12, typically with equal spacings, and are used to support a plurality of wafers in the assembled tower 10. The tower is typically semi-permanently placed in a semiconducting processing reactor (or an adjacent loading station) configured for one of a number of different processes. Multiple wafers are placed into the tower 10 and then simultaneously processed at either medium temperatures in the range of 400 to 700°C or high temperatures in the range of 1000 to 1380°C, as was previously described. The temperature depends in part on whether chemical vapor deposition, an anneal, or a thermal diffusion is being performed.

The illustrated tower 10 has four legs 12 although three legs 12 and even two legs 12 or possibly one leg 12 would suffice. Most typically, the multiple legs are attached to the bases 14 around slightly more than 180° of the periphery of the bases 14 so that the legs 12 dependably support the wafers but the wafer can be linearly inserted through the slots 16 by an automated robot supporting the wafer on a paddle traveling transversely to the longitudinal axis of the tower 10.

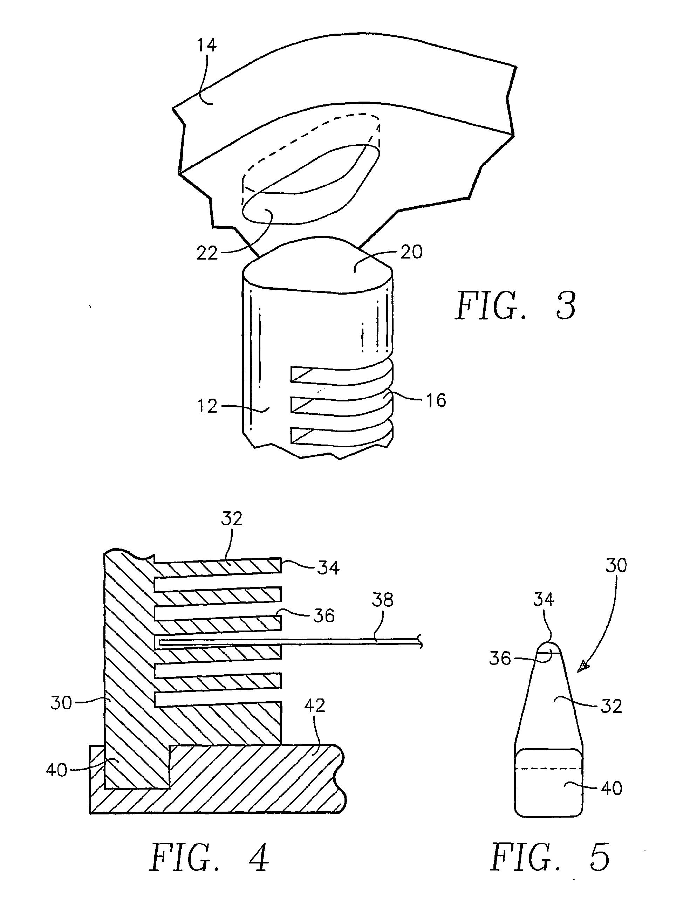

As shown in the FIG. 3, the legs may have a substantially constant wedge-shaped cross section exclusive of the teeth 16 extending to the leg ends 20. The wafers are supported on the teeth 16 at the more acutely shaped end of the wedge to reduce thermal shadowing. The bases 14 are formed with a similarly shaped blind mortise hole 22, and the rod end 20 is fit into the mortise hole 22 and secured therein. The non-cylindrical shape of the rod end 20 and the mortise hole 22 prevent rotation and thus increase the rigidity and ease of assembly and alignment of the fixture.

An alternate design illustrated in side cross section in FIG. 4 and axial plan view FIG. 5 produces a leg 30 having a shape generally resembling a banjo pick. Each leg has a plurality of teeth 32 having a generally wedge shape with a rounded tip 34. The teeth 34 are sloped upwardly at an angle of between 1 and 3°. However, the top surface of each teeth end 34 is formed with a polished horizontal portion 36 which supports a wafer 38. Again, the small areas of the supporting portion 34 and the surrounding structure reduce thermal shadowing.

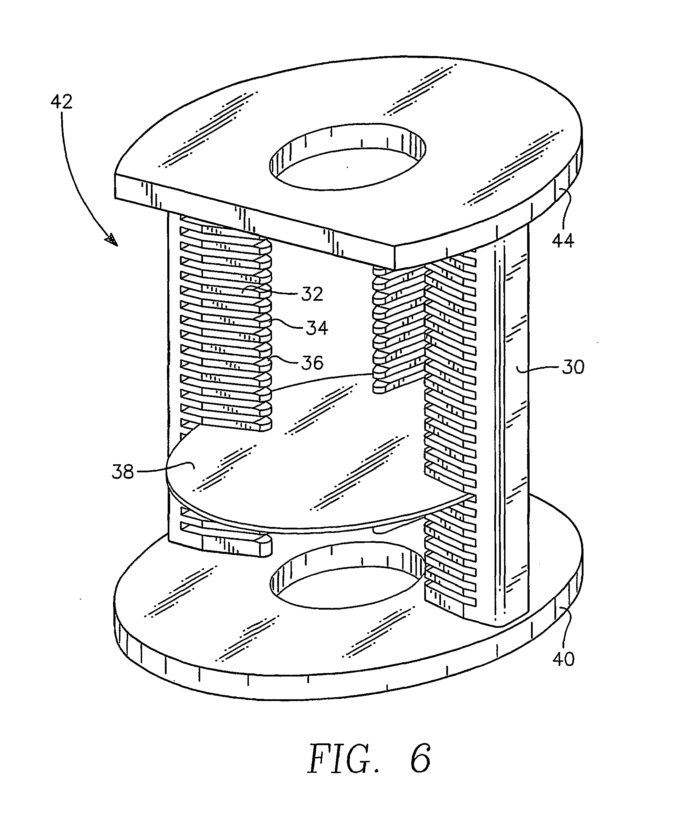

The leg 30 includes at each end a tenon 40 having a rounded rectangular shape that fits into a similarly shaped mortise (blind hole) in a base 42. An assembled tower 42, illustrated in the orthographic view of FIG. 6, includes three of the banjo-pick legs 30 joined at their end to two silicon bases 40, 44 for supporting a plurality of wafers 38 in a vertically offset arrangement.

An advantage of the longer banjo-pick legs 30 is that they can be sized such that the polished support portion 36 at the interior ends of the teeth 32 maybe advantageously positioned to support the wafers 38 at a radial position of between 69% and 72% of the radius of the wafer 38. The radial position of 1/√2=0.707 is the support position at which the weight of the wafer interior to the support radius equals that exterior to it. This balancing has the dual advantage of minimizing maximum wafer sag and of minimizing stress and resultant crystal slip in the supported wafer.

In this example, some of the members, particularly the legs 12, are formed of virgin polysilicon rather than Czochralski-grown monocrystalline or polycrystalline silicon.

Virgin polysilicon, hereinafter virgin poly, is a special type of polysilicon extensively manufactured for use in the semiconductor industry. Virgin poly is formed into relatively large ingots (diameters of up to approximately 15cm) by thermal chemical vapor deposition (CVD) of silicon using one or more of various silanes as the precursor gas which condenses on a heated seed rod drawn from a previously formed virgin poly ingot or formed into filaments by a float zone process. The virgin poly nucleates from the polycrystalline in the form of a hot seed rod and in the CVD process tends to form as crystalline arms or dendrites radiating from the seed rod with the appearance of a sun burst. Silane precursors for virgin poly include SiH₄, SiClH₃, SiCl₂H₂, SiCl₃H, and SiCl₄. Of these, SiHCl₃H is the most commonly used commercially, but monosilane (SiH₄) is sometimes used based on its historic usage in float-zone deposition. Typical thermal CVD temperatures range from 900°C to 1100°C. The major commercial suppliers of virgin poly are M.E.M.C., Inc., Hemlock Semiconductor, Advanced Silicon Materials, Inc., Mitsubishi, Wacker of Germany, and Tokuyama of Japan.

Virgin poly is the stock silicon material used to form the melt in the CZ process. It is grown with very high internal stress so that it easily shatters into small pieces to be melted as the CZ precursor.

Virgin poly is grown to very high levels of purity with metal impurity concentrations of 10⁻¹⁰cm⁻³ or less. Analyses have been made of a standard grade virgin poly having a maximum concentration for boron of 60 ppt (ppt being 1 part per trillion atomic, 1 × 10⁻¹²), for phosphorous of 140 ppt, for metals (such as Al, Ga, In, As, and Sb) of 20 ppt, and for carbon of 20 ppm (parts per million). Thus, even with some variation, the metal concentration is less than 1 ppb (parts per billion atomic). For ultra-pure virgin poly, these maximum concentrations are reduced to 20 ppt, 25 ppt, 10 ppt and 10 ppm. Resistivity of standard grade virgin poly has been measured to be above 1000 ohm-cm, and that of ultra-pure virgin poly above 5000 ohm-cm. This contrasts with Czochralski-grown polysilicon having various impurities of at least 100 ppb for heavy metals. Oxygen may be present in the virgin poly silicon but in amounts many orders of magnitude less than that required for forming silica. References herein to silicon members refer to members comprising a bulk material of substantially pure elemental silicon that is primarily tetrahedrally and covalently bonded together on an atomic scale.

Because virgin poly has very low levels of impurities, it is advantageously used in the legs 12, 30 which are in direct contact with the wafer during thermal processing. This advantage obtains even at the medium processing temperatures at which quartz has no softening problem. Long rods of virgin poly of length greater than the length of the legs are readily available.

On the other hand, the bases 14, 40 are relatively far removed from the wafers being processed so that they produce less wafer contamination. It would still be advantageous to form bases from virgin poly. However, in the generally cylindrical forms of the bases 14 of FIG. 1, the diameter of the base 14 must be greater than the diameter of the wafer being processed. Virgin poly is not generally available in ingots of diameter greater than 200mm as would be required for solid bases for processing 200mm wafers, much less 300mm wafers. The largest currently available diameter for virgin poly is about 150mm. Accordingly, the generally circular bases 14 are conveniently formed of single crystal silicon although CZ polysilicon would suffice. Ingots of CZ monocrystalline silicon are available with very large diameters for speciality applications.

As far as is known, virgin poly has not been used in silicon fixtures for supporting wafers in semiconductor processing. Due to the crystal structure of virgin poly, rods of the material distinct "grain" running generally longitudinally through the rod. Silicon rods are usually cut laterally, across the grain, using a scroll saw. Unfortunately, when used to make longitudinal cuts, conventional cutting techniques tend to split virgin poly rods along the grain, thus ruining the rod.

Virgin poly as delivered from its usual manufacturers is thus inappropriate for being machined into the complex shapes needed for legs and other structural members. Furthermore, the high internal stress present in commercially available virgin poly causes it to shatter or at least chip when subjected to the usual machining processes such as cutting, milling, turning, and slotting.

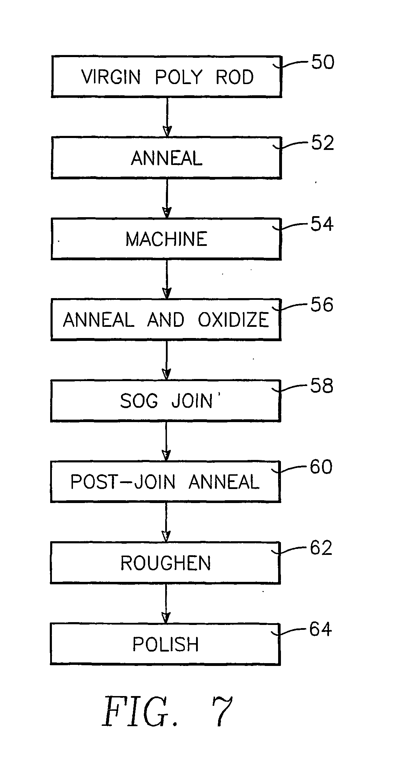

As a result, a more complex processing sequence, such as that illustrated in FIG. 7 is advantageously followed in forming virgin poly members, such as the legs, and assembling them into more complex structures. In step 50, a virgin poly rod is provided. Preferably, the virgin poly is formed by a CVD process using monosilane (SiH₄) since this precursor is free from any possible contaminants, such as chlorine. In the case of fabricating legs, the virgin poly rod should have a length greater than that required for the legs, and its diameter is advantageously somewhat more than twice the maximum transverse dimension of the legs to maximize the material utilization of the cylindrical virgin poly rods. In step 52, the virgin poly ingot is annealed for more than an hour at a temperature at least above 1025°C, which is the platicizing temperature for silicon, and below its melting point of 1414°±2°C. The annealing temperature should be at least 100°C above the temperature used in the CVD deposition temperature of the rod. Thus a minimum annealing temperature of 1200°C would suffice for the known sources of virgin poly. The annealing relieves the internal strain of virgin poly but is not believed to significantly change its crystalline structure.

In step 54, the annealed virgin poly rod is machined into its desired shape. Because of the annealing step 52, standard machining procedures may be followed without undue concern of fracturing the virgin poly. The first two machining steps should cut it to the desired length and turn the rod to remove the typically present surface doming to thus provide a smooth cylindrical rod. Subsequent machining steps include longitudinal sectioning the cylindrical rod into wedge-shaped stock members and machining the wedges into the desired leg shape. It has been found that sectioning of the rods maybe performed with a hydraulic jet, and the teeth may be cut with a rotary slotter. Other types of machining can be used for producing the relatively complex shapes described here.

In step 56, the machined members, for example, the legs and the bases, even if they are Czochralski silicon, are annealed at ambient at between 1025 and 1416°C in an atmospheric ambient so that the machined silicon is oxidized.

In step 58, the legs are joined to the bases. The —— joining technique uses a thinned spin-on glass (SOG). SOG is a generic term for chemicals widely used in semiconductor fabrication to form silicate glass layers in integrated circuits. Commercial suppliers include Allied Signal, Filmtronics of Butler, Pennsylvania, and Dow Coming. SOG includes one or more chemicals containing both silicon and oxygen, such as tetraethylorthosilicate (TEOS) or its modifications or organo-silanes such as siloxanes. It is preferred that the SOG not contain boron or phosphorous, as is commonly done for integrated circuits. The silicon and oxygen containing chemical is dissolved in an evaporable carrier, such as alcohol, methyl isobutyl ketone or a volatile methyl siloxane blend. In semicondoctor fabrication, a few drops of relatively viscous SOG are dropped onto a wafer, and the wafer is spun at high speeds to create a uniformly thin layer of the SOG. Thereafter, the coated wafer is annealed at between 200 and 900°C, and the SOG decomposes to form silicate glass having the approximate composition SiO₂. In the joining step 58 of the invention the SOG is thinned with the addition of more solvent, and is coated to sufficient thickness on either or both of leg tenon and the base mortise to fill the void between the leg and base after they have been assembled together into the tower structure.

In step 60, the assembled tower is again annealed preferably at between 1025 and 1414°C, which is sufficient to vitrify the SOG and bond together the two oxidized silicon parts.

An anneal at between 600 and 900°C provides superior SOG vitrification in the restricted geometry of the bonded interface, and the temperatures above 1025°C provide better bonding to the oxidized surfaces and relieve structural distortions.

In step 62, the assembled tower is subjected to a surface treatment which introduces controlled sub-surface damage in the underlying silicon. Such treatments were practiced previously to roughen the backside of wafers to getter impurities from the wafer. Treatment methods include bead blasting, lapping, and grinding among several possibilities.

In step 64, the wafer bearing surfaces 34 are polished to a mirror finish, preferably having a surface roughness of less than 1nm but a 10nm roughness would be acceptable. A chemical mechanical polishing (CMP) method used for polishing wafers can be adapted for polishing the more confined wafer bearing surfaces. Two typical CMP methods include use of a colloidal silica polishing agent in an alkali liquid carrier or of a diamond paste in either a liquid carrier or impregnated in a flexible polishing belt Hengst in U.S. Patent 5,931,666 references an ASTM standard for numerical value of surface roughness. Alternatively, a mirror surface can be visually determined by viewing the surface. A mirror surface looks like a silvered mirror, though perhaps of a different color, in that it reflects light at equal angles from the normal of the surface. Any signficant defects, texture, or speckling indicates a lack ofa mirror surface.

The described examples enable the fabrication of monocrystalline silicon, polycrystalline silicon, or virgin polysilicon towers, for use in the manufacture of semiconductor wafers and the like.

Experience has shown that silicon towers reduce the number of added particles, see FIG. 1, to less than 10 per 200mm wafer, and there is no long-term degradation in this performance.

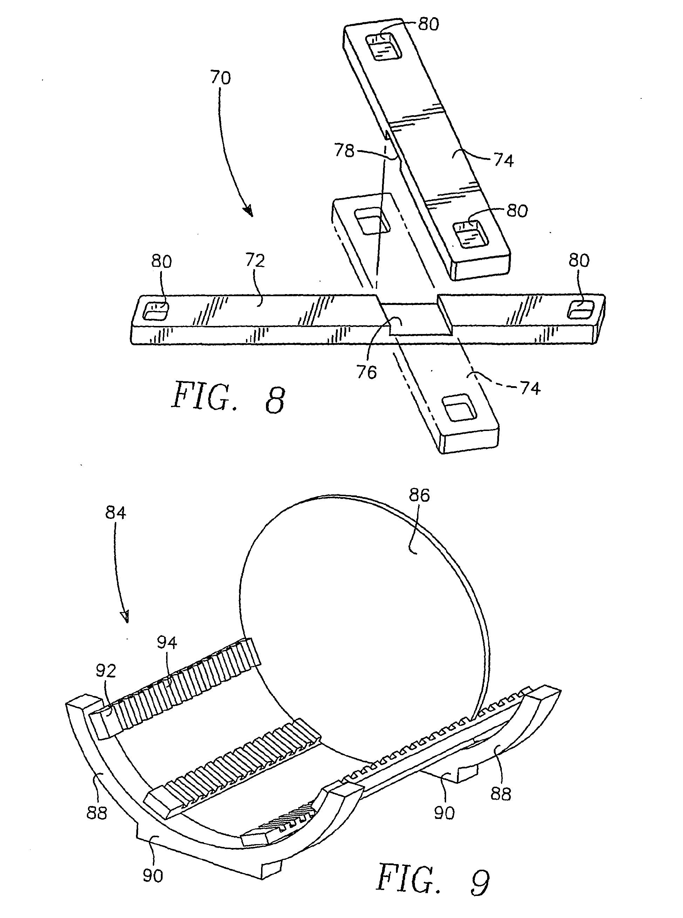

The invention is not limited to the tower of the general configuration illustrated in FIG. 2. Alternatively, as illustrated in the orthographic view of FIG. 8, a tower base 70 may be fabricated from two silicon cross legs 72, 74 formed with matching central notches 76, 78. The cross legs 72, 74 arranged at an angle to each other are then joined together at the notches 76, 78 in the manner of Lincoln logs. Because the side legs of the tower are arranged along about 210° of a circle to allow both the support and insertion of wafers, the cross legs 72, 74 have longer and shorter ends with respect to the notches 76, 78, and the ends of the same size are set at an obtuse angle between them. Each of the cross legs 72, 74 includes blind mortise holes 80 at its ends to receive the tenons of the side legs of the tower. Advantageously, the cross legs 72, 74 are formed of virgin polysilicon, and an entire virgin poly tower is formed and joined according to the forming process of FIG. 7.

Other configurations of a base are possible in which two or more silicon members are joined together and with the silicon legs.

Though not part of the invention, similar techniques can be usefully applied to a wafer boat 84 illustrated in the orthographic view of FIG. 9 for supporting multiple wafers 86 held substantially vertical and spaced along a horizontal direction. The boat 84 includes two arc-shaped silicon end bases 88 with feet 90 supporting the boat 84 within a horizontal furnace. The boat 84 also includes four silicon arms 92 (which would be called legs for a tower orientation). Vertical slots 94 are cut in the arms 92 to receive the wafers. The ends of the arms 92 are joined to the end bases 88. Once again, advantageously, the entire boat 84 is composed of virgin polysilicon, and the virgin poly boat is formed and joined according to the method of FIG. 7. For a boat, the number of arms 92 can be reduced, even to two aims. Indeed, it is possible to provide a boat function by cutting multiple parallel slots in a single longitudinally silicon member to form a rack, advantageously composed of virgin polysilicon.

Towers using silicon structural members experience less deformation during high-temperature process applications. Since the source material is the same quality as the wafers material, particulate contamination, crystal slip, and metallic contaminants inherent with known materials such as silicon carbide is virtually eliminated. Furthermore, thermal shadowing is reduced since, for the described towers, the wafer is supported on a narrow tooth ends and since the fixture material and wafer material have substantially identical physical properties and critical constants. Silicon towers manufactured according to the described methods have tolerances and expected service life unachievable with fixtures made from commonly used materials such as quartz or silicon carbide. The described methods of fabrication of silicon towers provide advantages as the industry moves to 300mm and larger wafer diameters.

Virgin poly legs have the advantage of extremely low impurities of no more than 10 ppt. Therefore, the virgin poly tower introduces far fewer impurities into the wafers being processed. However, it is noted that the quoted impurity levels for virgin poly are affected, at least near the surface, by the machining and ambient annealing steps. Nonetheless, at depths of greater than approximately 10µm, the lower impurity levels are maintained and the deep volume does not constitute a source of impurities.

## Claims

1. A method of forming a silicon tower configured to support a plurality of wafers, comprising the steps of:
providing at least one silicon member;
annealing said at least one silicon member at a first annealing temperature of at least 1025°C;
machining said at least one silicon member into a plurality of legs including machining slots transversely to longitudinal axes of said legs for forming teeth for supporting said plurality of wafers;
assembling and joining at least three of said legs to two silicon bases having holes formed therein to receive opposing ends of said legs, said joining step including applying a spin-on glass solution comprising silicon and oxygen to at least one of a respective one of said legs and a respective one of said bases at an interface therebetween to be joined, thereby forming an assembled structure; and
annealing said assembled structure at a second annealing temperature of above 600°C.

2. A method of claim 1 wherein least said legs comprise virgin polysilicon.

3. The method of Claim 1, wherein said second annealing temperature is at least 1025°C.

4. The method of any of the preceding claims, further comprising the subsequent step of roughening a surface of said assembled structure.

5. The method of any of the preceding claims, further comprising the subsequent step of polishing a contact area between said teeth and said wafers to a mirror finish.

6. The method of any of the preceding claims, wherein each of said bases comprises a plurality of base parts assembled and joined together in said assembling and joining step.

7. A silicon tower configured to support a plurality of wafers, comprising:
at least three silicon legs (12) including slots machined transversely to longitudinal axes of said legs for forming teeth (16) for supporting said plurality of wafers; and
two silicon bases (14) having holes (22) formed therein receiving opposing ends (20) of said legs (12);
**characterized by** annealed silicate glass at each interface between a respective one of said legs (12) and a respective one of said bases (14), joining said legs to said bases.

8. The silicon tower of claim 7 wherein said legs have on opposed ends two non-cylindrical attachment parts (20), and said silicon bases have non-cylindrical holes (22) for receiving and surrounding said attachment parts of said legs.

9. The silicon tower of claim 7 or claim 8 wherein said legs comprise virgin polysilicon.

10. The silicon tower of any one of claims 7-9, wherein each of said bases comprises virgin polysilicon.

## Patentansprüche

1. Verfahren zur Bildung eines Siliziumturms, welcher zur Abstützung einer Vielzahl von Wafern bzw. Halbleiterscheiben konfiguriert ist, wobei das Verfahren die folgenden Schritte aufweist:
Bereitstellung mindestens eines Silizium-Bauteils;
Anlassen des mindestens einen Silizium-Bauteils bei einer ersten Anlasstemperatur von mindestens 1025°C;
Maschinelle Verarbeitung des mindestens einen Silizium-Bauteils in eine Vielzahl von Abschnitten, einschließlich der maschinellen Herstellung von Schlitzen quer zu Längsachsen der Abschnitte zur Bildung von Zinken für die Abstützung der Vielzahl von Wafern;
Montieren und Verbinden von mindestens drei Abschnitten auf bzw. mit zwei Silizium-Unterlagen mit darin ausgebildeten Bohrungen zur Aufnahme gegenüberliegender Enden der Abschnitte, wobei der Verbindungsschritt die Aufbringung einer Spin-On-Glas-Lösung, welche Silizium und Sauerstoff enthält, auf mindestens einen jeweiligen Abschnitt und eine jeweilige Unterlage an einer zu verbindenden Schnittstelle zwischen den beiden einschließt, wodurch eine montiertes bzw. zusammengebautes Gefüge gebildet wird; und
Anlassen des zusammengebauten bzw. montierten Gefüges bei einer zweiten Anlasstemperatur von über 600°C.

2. Verfahren nach Anspruch 1, **dadurch gekennzeichnet, dass** zumindest die Abschnitte natives Polysilizium aufweisen.

3. Verfahren nach Anspruch 1, **dadurch gekennzeichnet, dass** die zweite Anlasstemperatur mindestens 1025°C beträgt.

4. Verfahren nach einem der vorhergehenden Ansprüche, welches des Weiteren den nachfolgenden Schritt des An- bzw. Aufrauhens einer Oberfläche des zusammengebauten Gefüges aufweist.

5. Verfahren nach einem der vorhergehenden Ansprüche, welches des Weiteren den nachfolgenden Schritt des Polierens eines Kontaktbereichs zwischen den Zinken und den Wafern auf Hochglanz aufweist.

6. Verfahren nach einem der vorhergehenden Ansprüche, **dadurch gekennzeichnet, dass** jede Unterlage bzw. Basis eine Vielzahl von Unterlage- bzw. Basisabschnitten aufweist, welche in dem Montage- und Verbindungsschritt zusammengebaut und miteinander verbunden werden.

7. Siliziumturm, welcher zur Abstützung einer Vielzahl von Wafern konfiguriert ist und Folgendes aufweist:
mindestens drei Silizium-Abschnitte (12), welche Schlitze einschließen, die quer zu Längsachsen der Abschnitte zur Ausbildung von Zinken (16) für die Abstützung der Vielzahl von Wafern maschinell hergestellt sind; und
zwei Silizium-Unterlagen (14) mit darin ausgebildeten Bohrungen (22), welche gegenüberliegende Enden (20) der Abschnitte (12) aufnehmen;
**gekennzeichnet durch** angelassenes Silikatglas an jeder Schnittstelle zwischen einem jeweiligen Abschnitt (12) und einer jeweiligen Unterlage bzw. Basis (14), wodurch die Abschnitte mit den Unterlagen verbunden werden.

8. Siliziumturm nach Anspruch 7, **dadurch gekennzeichnet, dass** die Abschnitte an ihren gegenüberliegenden Enden zwei nicht-zylindrische Befestigungsteile (20) aufweisen, und dass die Silizium-Unterlagen nicht-zylindrische Bohrungen (22) zum Aufnehmen und Umschließen der Befestigungsteile der Abschnitte aufweisen.

9. Siliziumturm nach Anspruch 7 oder Anspruch 8, **dadurch gekennzeichnet, dass** die Abschnitte natives Polysilizium aufweisen.

10. Siliziumturm nach einem der Ansprüche 7 bis 9, **dadurch gekennzeichnet, dass** jede Unterlage bzw. Basis natives Polysilizium aufweist.

## Revendications

1. Procédé de formation d'une tour de silicium configurée pour soutenir une pluralité de plaquettes, comprenant les étapes qui consistent :
à fournir au moins un élément de silicium ;
à soumettre ledit au moins un élément de silicium à un recuit à une première température de recuit d'au moins 1025°C ;
à usiner ledit au moins un élément de silicium en une pluralité de pieds comportant des fentes d'usinage transversales par rapport à des axes longitudinaux desdits pieds pour former des dents destinées à soutenir ladite pluralité de plaquettes ;
à assembler et à réunir au moins trois desdits pieds à deux bases de silicium ayant des trous qui formés dedans pour recevoir des extrémités opposées desdits pieds, ladite étape de jonction comportant le fait d'appliquer une solution de verre centrifugé comprenant du silicium et de l'oxygène à au moins un pied respectif parmi lesdits pieds et une base respective parmi lesdites bases, au niveau d'une interface entre eux, à réunir, formant ainsi une structure assemblée ; et
à soumettre ladite structure assemblée à un recuit à une deuxième température de recuit au-dessus de 600°C.

2. Procédé de la revendication 1 dans lequel au moins lesdits pieds comprennent du polysilicium vierge.

3. Procédé de la revendication 1, dans lequel ladite deuxième température de recuit est d'au moins 1025°C.

4. Procédé de l'une des revendications précédentes, comprenant en outre l'étape suivante qui consiste à rugosifier une surface de ladite structure assemblée.

5. Procédé de l'une des revendications précédentes, comprenant en outre l'étape suivante qui consiste à polir une surface de contact entre lesdites dents et lesdites plaquettes jusqu'à obtenir un fini miroir.

6. Procédé de l'une des revendications précédentes, dans lequel chacune desdites bases comprend une pluralité de parties de bases assemblées et réunies dans lesdites étapes d'assemblage et de jonction.

7. Tour de silicium configurée pour soutenir une pluralité de plaquettes, comprenant :
au moins trois pieds de silicium (12) comportant des fentes usinées de manière transversale par rapport à des axes longitudinaux desdits pieds pour former des dents (16) destinées à soutenir ladite pluralité de plaquettes ; et
deux bases de silicium (14) ayant des trous (22) qui sont formés dedans recevant des extrémités opposées (20) desdits pieds (12) ;
**caractérisée par** un verre de silicate recuit à chaque interface entre un pied respectif desdits pieds (12) et une base respective desdites bases (14), réunissant lesdits pieds auxdites bases.

8. Tour de silicium de la revendication 7 dans laquelle lesdits pieds ont sur des extrémités opposées, deux parties de fixation (20) non-cylindriques, et lesdites bases de silicium ont des trous (22) non-cylindriques pour recevoir et entourer lesdites parties de fixation desdits pieds.

9. Tour de silicium de la revendication 7 ou de la revendication 8 dans laquelle lesdits pieds comprennent du polysilicium vierge.

10. Tour de silicium de l'une quelconque des revendications 7 à 9, dans laquelle chacune desdites bases comprend du polysilicium vierge.
